Europäisches Patentamt

European Patent Office

Office européen des brevets

(19)

(11)  EP 1 659 630 A1

(12)  EUROPEAN PATENT APPLICATION

(43) Date of publication:
24.05.2006  Bulletin 2006/21

(51) Int Cl.:
*H01L 27/146* (2006.01)

(21) Application number: 04257208.1

(22) Date of filing: 18.11.2004

(84) Designated Contracting States:
AT BE BG CH CY CZ DE DK EE ES FI FR GB GR
HU IE IS IT LI LU MC NL PL PT RO SE SI SK TR
Designated Extension States:
AL HR LT LV MK YU

(71) Applicant: STMicroelectronics (Research &
Development)
Limited
Marlow,
Buckinghamshire SL7 1YL (GB)

(72) Inventor: Raynor, Jeffrey
Edinburgh EH12 5HZ (GB)

(74) Representative: Cooper, John et al
Murgitroyd & Company,
Scotland House,
165-169 Scotland Street
Glasgow G5 8PL (GB)

(54)  **CMOS image sensor**

(57)  A CMOS image sensor is provided, being arranged to comprise a radiation incident surface on the reverse surface thereof. The radiation radiation incident surface of the CMOS can comprise a thinned substrate layer, such that the CMOS image sensor improves infrared response without the need for implanting deeper radiation collection junctions.

Fig. 2

EP 1 659 630 A1

**Description**

The present invention relates to a CMOS image sensor, in particular to improvements in the structure and function of a CMOS image sensor.

Electromagnetic radiation in the infra-red spectrum has a longer wavelength than that in the visible spectrum, which produces a much longer penetration depth in silicon. For example, infra-red light having a wavelength of around 850nm, which is a common wavelength for communications applications, has a penetration depth of around $30\mu$m in silicon.

The relationship between incident wavelength and light penetration depth in a given material defines the material's optical absorption coefficient. Selected other values, as discussed in Sze "Physics of Semiconductor Devices" 2nd Edition, Chapter 13 "Photodetectors", are shown in the following table:

| Wavelength | Light Penetration Depth ($\mu$m) |
|---|---|
| 450 | 0.5 |
| 550 | 2 |
| 650 | 5 |
| 750 | 10 |
| 850 | 30 |

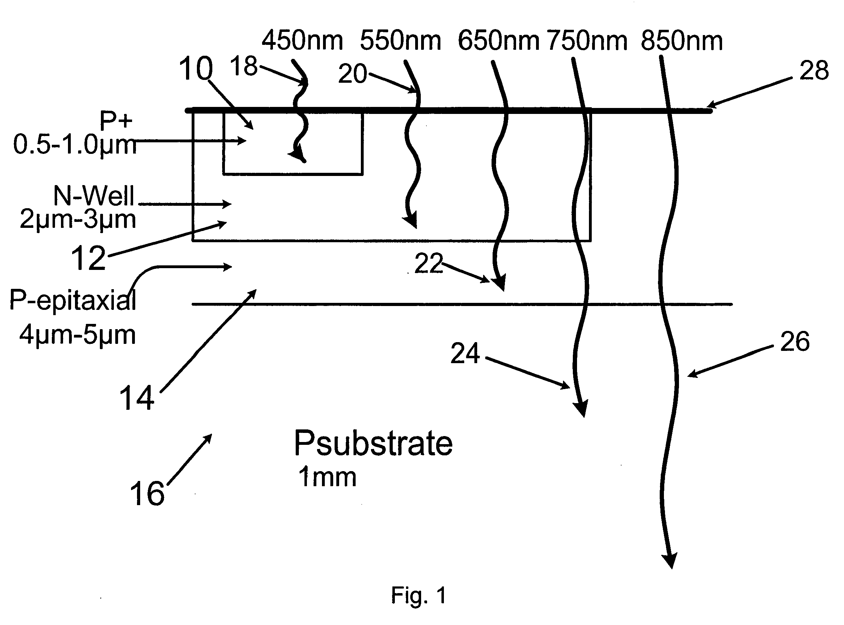

Fig. 1 shows how the light penetration depths relate to a typical CMOS image sensor cross section.

Efficient collection of the photogenerated electrons requires that the collection mechanism is located at or close to the penetration depth. The collection is assisted by the electric field produced by a PN junction.

If the junction is not located at an appropriate depth, i.e. a depth at or around the penetration depth of radiation to be detected, some the photogenerated electrons will diffuse to the junction, however a significant proportion will recombine and the signal will be lost. Typically, the quantum efficiency of a sensor having a junction at an inappropriate depth is 20%-30%, whereas the quantum efficiency of a sensor having a junction at an appropriate depth can be as high as 80%.

Previously, the appropriate depth of P-N junction was guaranteed in an IR image sensor by either growing an epitaxial layer on a substrate to the thickness necessary to achieve a junction at the appropriate depth or by implanting a well structure deep enough to achieve a junction at the appropriate depth. However, both of these techniques significantly increase the fabrication time leading to increased cost.

Furthermore, in a typical CMOS process, the depth of the Epitaxial layer / implant is usually 3pm - $5\mu$m. Increasing this depth will change the performance of the transistors requiring the models for the process to be re-extracted, which would be a time consuming and expensive process.

It is therefore desirable to provide an image sensor sensitive to infra-red radiation that can use standard CMOS processing technologies, but still maintain a reasonable quantum efficiency.

According to a first aspect of the present invention, there is provided a CMOS image sensor arranged to comprise a radiation incident surface on the reverse surface thereof.

An obverse surface of the CMOS image sensor is defined as the surface which is subject to steps of ion implantation to form active element and photodiode wells therein, and optionally to have pixel sensing circuitry fabricated thereupon. The reverse surface is defined as the surface opposed to the obverse surface, and can also be known as the "rear" or "back" surface. A radiation incident surface is defined as a surface upon which radiation impinges.

Preferably, the radiation incident surface comprises a thinned substrate layer.

By a thinned substrate layer, we mean a substrate layer, for example a wafer, that has been thinned to have a thickness that is less than the thickness normally found for standard front-illuminated CMOS image sensors. The thinning can be carried out by any suitable process, most preferably by backlapping. There are two known types of thinning processes - mechanical grinding and chemical etching. Mechanical grinding is a quick method of removing silicon, but adds stress to the final wafer which can affect the performance, e.g. higher "dark current" (diode leakage) in a photosensor. Chemical etching avoids this stress, but is a very slow and therefore expensive process. Backlapping is commonly achieved by a mechanical grinding process where hundreds of microns of silicon are removed followed by a wet-etch process where a few microns to tens of microns are removed. This combines the speed of mechanical grinding but avoids the stress inducing part.

Preferably, the thinned substrate layer has a thickness approximately equal to the sum of a radiation absorption depth and a radiation collection junction depth.

The radiation absorption depth is the depth, as measured from the radiation incident surface, that the incident radiation will penetrate before being absorbed, and hence lost to detection. The radiation collection junction depth is the depth as measured from the obverse surface of the CMOS image sensor, at which the P-N junction is formed.

Preferably, the thinned portion has a thickness that results in infra-red radiation being absorbed at or around the depth of the collection junction.

This means that the thinned portion can be any thickness within a range of thicknesses that may correspond to a successful absorption of radiation with a range of wavelengths in the infra-red region. The absorption of the radiation does not have to be exactly at the precise depth of the collection (P-N) junction, and so a thickness can be chosen that will give an optimised absorption for a specific desired wavelength of radiation, but also an improved absorption of a range of wavelengths that comprises the specific desired wavelength.

It will also be appreciated that the absorption depth of radiation of a specific wavelength is a statistical value, that is, one would normally expect radiation of a specific wavelength to be absorbed at a range of absorption depths, the range being well represented by the given figure for absorption depth. The concept of being absorbed "at" a particular depth therefore includes some minor variations around that depth for specific incoming radiation beams.

Preferably, the thinned portion has a thickness of between thirty and forty micrometers.

According to a second aspect of the invention, there is provided a method of forming a CMOS image sensor, comprising the step of arranging the sensor to comprise a radiation incident surface on the reverse surface thereof.

Preferably, the method comprises the step of thinning a substrate layer of the radiation incident surface.

Preferably, the step of thinning a substrate layer of the radiation incident surface comprises forming the substrate layer to have a thickness approximately equal to the sum of a radiation absorption depth and a radiation collection junction depth.

Preferably, the thinned portion has a thickness that results in infra-red radiation being absorbed at or around the depth of the collection junction.

Preferably, the thinned portion has a thickness of between thirty and forty micrometers.

According to a third aspect of the invention, there is provided a method of sensing an image, comprising the step of causing radiation to be incident on a reverse surface of a CMOS image sensor.

The present invention will now be described, by way of example only, with reference to the accompanying drawings, in which:

Fig. 1 shows a prior art image sensor and illustrates the light penetration depth of incident radiation; and

Fig. 2 shows an image sensor in accordance with a first embodiment of the invention.

Backside illumination of image sensors incorporating charge coupled devices (CCDs) is well known, as it has been desirable to overcome the poor optical transmission properties of the front-side control electrodes. An example of a back-illuminated CCD image sensor can be seen in US 4,266,334, to Edwards et. al.

However, it has not previously been known to have backside illumination of CMOS image sensors. The electrodes of a CCD are required to generate an alternating series of "potential wells" in which the photo-electric generated charge is first collected and then transported around the device. This technique led to the name "Charge Coupled Device". The noise-free charge-transfer technique of a CCD partially mitigates against the reduction in photosensitivity caused by the optical absorbtion of the front electrodes.

In contrast to this technique, a CMOS photo sensor collects the photo generated charge in an implanted well and does not require the surface electrode. As a result of this more light-efficient sturcture, there is neither a requirement or a benefit of having back-illuminated CMOS device for traditional operation.

Fig. 1 shows selected components of a typical CMOS image sensor, including a P+ active element 10, an N-well 12, a P-epitaxial layer 14 and a P type substrate 16. Illustrated incident photons 18, 20, 22, 24 and 26 have wavelengths 450, 550, 650, 750 and 850 nm respectively.

As indicated in Fig. 1, a typical P+ well 10 will have a depth of between about 0.5 $\mu$m to about 1.0 $\mu$m as measured from the light incident surface 28, while a typical N-well 12 will have a depth of about 2 $\mu$m to about 3 $\mu$m. The P-epitaxial layer 14 will have a depth of about 4 $\mu$m to about 5 $\mu$m, and the P substrate has a depth of 1mm, i.e. 1000 $\mu$m.

The border between the N-well 12 and the P-epitaxial layer 14 defines a P-N junction 30. As can be seen from Figure 1, the penetration depth of photons with longer wavelength, i.e photons 22, 24 and 26 is greater than the depth of a standard silicon PN junction 30.

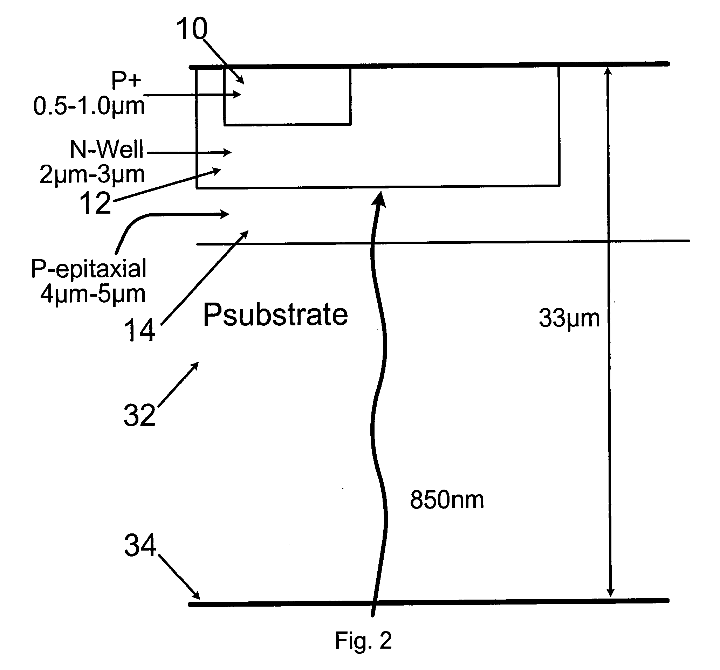

Selected components of a CMOS image sensor according to a preferred embodiment are illustrated in Figure 2. Like components are labelled with like reference numerals.

To make the CMOS image sensor of figure 2, the processed silicon wafer is thinned, for example using a backlapping process. The substrate 32 is thinned to a thickness of merely about 35 $\mu$m. This is a drastic reduction in size when compared to the 1mm depth of the substrate 16 of the image sensor of Fig. 1.

There is of course a general overriding desire to manufacture sensors that are small in size, but a reduction of thickness of this magnitude has not previously been considered due to the greatly increased fragility of such a wafer, which would be seen to result in an undesirable wastage due to breakage. However, the inventor has realised that such a thinned wafer can be useful to construct an improved IR sensor, thus providing an advantageous effect to counteract any problems with the wafer's fragility.

The sensor is then illuminated from the reverse side, via light incident surface 34. The wafer thinning can be optimized for the illumination:

$$\text{Wafer thickness = Optical Absorption Depth +}$$
$$\text{Collection Junction Depth.}$$

For the case of a sensor with an Nwell / Pepitaxial collection with junction depth of $3\mu$m and 850nm wavelength illumination (and hence penetration depth of $30\mu$m), the optimal wafer thickness is $33\mu$m.

Thus, the invention improves IR response without the need for implanting a deeper junction.

As the device is illuminated from the reverse side, it needs to be packaged in a suitable manner. For example, bump-bonded to a substrate with conductors, mounted on a lead-frame which has a hole allowing light to pass.

Various packaging technologies are particularly suitable for this technique. For example the ShellCase packaging technique, glues a glass substrate to both the front and rear surfaces of the wafer: US 6,040,235 Badehi " Methods and apparatus for producing integrated circuit devices".

Thin wafers are particularly fragile, so it is usual for the thinning process to be carried out near the packaging factory. This minimizes damage to the wafer during transport. Alternatively, a wafer-scale packaging technique could be particularly advantageous. This would allow a support substrate to be bonded to the front-side of a wafer before it was thinned, adding mechanical support and strengthening the assembly. Once the support is in place, the silicon wafer could be thinned without it becoming fragile.

An image sensor constructed in this way may be suitable for a number of applications including an optical mouse, an IR sensitive digital camera, or an IR communications device. The skilled man will readily appreciate the steps that are required to incorporate the image sensor of the invention into any of these products.

Various improvements and modifications can be made to the above without departing from the scope of the invention. In particular, the skilled man will realise the doping types of the specific embodiment illustrated may straightforwardly be switched.

**Claims**

1. A CMOS image sensor arranged to comprise a radiation incident surface on the reverse surface thereof.

2. The CMOS image sensor of claim 1, wherein the radiation incident surface comprises a thinned substrate layer.

3. The CMOS image sensor of claim 2, wherein the thinned substrate layer has a thickness approximately equal to the sum of a radiation absorption depth and a radiation collection junctio depth.

4. The CMOS image sensor of claim 3, wherein the thinned portion has a thickness that results in infra-red radiation being absorbed at or around the depth of the collection junction.

5. The CMOS image sensor of claim 2 or claim 3, wherein the thinned portion has a thickness of between twenty and forty micrometers.

6. An optical mouse comprising the CMOS image sensor of any preceding claim.

7. An IR sensitive digital camera comprising the CMOS image sensor of any of claims 1-5.

8. A communications device comprising the CMOS image sensor of any of claims 1-5.

9. A method of forming a CMOS image sensor, comprising the step of arranging the sensor to comprise a radiation incident surface on the reverse surface thereof.

**10.** The method of claim 9, comprising the step of thinning a substrate layer of the radiation incident surface.

**11.** The method of claim 10, wherein the step of thinning a substrate layer of the radiation incident surface comprises forming the substrate layer to have a thickness approximately equal to the sum of a radiation absorption depth and a radiation collection junction depth.

**12.** The method of claim 11, wherein the thinned portion has a thickness that results in infra-red radiation being absorbed at or around the depth of the collection junction.

**13.** The method of claim 11 or claim 12, wherein the thinned portion has a thickness of between thirty and forty micrometers.

**14.** A method of sensing an image, comprising the step of causing radiation to be incident on a reverse surface of a CMOS image sensor.

P+
0.5-1.0µm

N-Well
2µm-3µm

12

P-epitaxial
4µm-5µm

14

16

Psubstrate
1mm

10
18
20

22

24

26

28

450nm 550nm 650nm 750nm 850nm

Fig. 1

EP 1 659 630 A1

P+
0.5-1.0µm

N-Well
2µm-3µm

12

P-epitaxial
4µm-5µm

14

Psubstrate

32

34

10

850nm

33µm

Fig. 2

7

**European Patent Office**

**EUROPEAN SEARCH REPORT**

Application Number

EP 04 25 7208

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2004/005729 A1 (ABE TAKASHI ET AL) 8 January 2004 (2004-01-08) * paragraphs [0025], [0062], [0091], [0092] * ----- | 1-14 | H01L27/146 |
| X | US 6 169 319 B1 (MALINOVICH YACOV ET AL) 2 January 2001 (2001-01-02) * column 4, lines 7-13,56 - column 5, line 6 * * column 6, line 39 - column 7, line 23 * ----- | 1,2,5,9, 10,14 | |
| X | US 2001/017344 A1 (AEBI VERLE W) 30 August 2001 (2001-08-30) * paragraphs [0005], [0039] - [0042] * ----- | 1,2,9, 10,14 | |
| X | WO 2004/070785 A (INTEVAC, INC) 19 August 2004 (2004-08-19) * page 5, lines 8-26 * * page 8, lines 29-34 * * page 9, line 15 - page 10, line 4 * * page 12, lines 4-31 * ----- | 1,2,5,9, 10,13,14 | |

TECHNICAL FIELDS
SEARCHED (Int.Cl.7)

H01L

The present search report has been drawn up for all claims

| Place of search | Date of completion of the search | Examiner |
|---|---|---|
| The Hague | 22 March 2005 | Cabrita, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 25 7208

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2005

| Patent document cited in search report | | Publication date | Patent family member(s) | | Publication date |
|---|---|---|---|---|---|
| US 2004005729 | A1 | 08-01-2004 | JP | 2003273343 A | 26-09-2003 |
| US 6169319 | B1 | 02-01-2001 | US | 6168965 B1 | 02-01-2001 |
| US 2001017344 | A1 | 30-08-2001 | US | 6285018 B1 | 04-09-2001 |
| | | | WO | 02065751 A2 | 22-08-2002 |
| | | | AU | 6107300 A | 05-02-2001 |
| | | | CA | 2379956 A1 | 25-01-2001 |
| | | | EP | 1204993 A1 | 15-05-2002 |
| | | | EP | 1306906 A1 | 02-05-2003 |
| | | | JP | 2003507870 T | 25-02-2003 |
| | | | WO | 0106571 A1 | 25-01-2001 |
| WO 2004070785 | A | 19-08-2004 | US | 2004169248 A1 | 02-09-2004 |
| | | | US | 2004180462 A1 | 16-09-2004 |
| | | | US | 2004245593 A1 | 09-12-2004 |
| | | | WO | 2004070785 A2 | 19-08-2004 |

EPO FORM P0459

For more details about this annex : see Official Journal of the European Patent Office, No. 12/82